Europäisches Patentamt

European Patent Office

Office européen des brevets

(19)

(11) Veröffentlichungsnummer: **0 277 377**
**A1**

(12) **EUROPÄISCHE PATENTANMELDUNG**

(21) Anmeldenummer: **87202456.7**

(22) Anmeldetag: **09.12.87**

(51) Int. Cl.⁴: **H03G 11/00**

(30) Priorität: **13.12.86 DE 3642618**

(43) Veröffentlichungstag der Anmeldung:
**10.08.88 Patentblatt 88/32**

(84) Benannte Vertragsstaaten:
**DE FR GB IT**

(71) Anmelder: **Philips Patentverwaltung GmbH**
**Wendenstrasse 35 Postfach 10 51 49**
**D-2000 Hamburg 1(DE)**

(84) **DE**

(71) Anmelder: **N.V. Philips' Gloeilampenfabrieken**
**Groenewoudseweg 1**
**NL-5621 BA Eindhoven(NL)**

(84) **FR GB IT**

(72) Erfinder: **Wölber, Jörg**
**Taubenstrasse 32**
**D-2080 Pinneberg(DE)**
Erfinder: **Kröner, Klaus**
**Immenhorstweg 94**
**D-2000 Hamburg 65(DE)**

(74) Vertreter: **Peters, Carl Heinrich, Dipl.-Ing. et al**
**Philips Patentverwaltung GmbH**
**Wendenstrasse 35 Postfach 10 51 49**
**D-2000 Hamburg 1(DE)**

(54) **Schaltungsanordnung zur Bildung eines begrenzten Stromes.**

(57) In einer Schaltungsanordnung zur Bildung eines in seiner Größe auf einen durch wenigstens einen Grenzwert berandeten Aussteuerungsbereich begrenzten Ausgangsstromes aus einem Eingangsstrom wird eine Begrenzung auch hochfrequenter Ströme aufgrund einer Vermeidung von Stromaufteilungen oder Sättigungseffekten dadurch ermöglicht, daß die Schaltungsanordnung ein Stromverknüpfungselement (1) zur Bildung einer wenigstens nahezu linearen Kombination des Eingangsstromes (IE), des Ausgangsstromes (IA) und eines festen Referenzstromes (IR) sowie wenigstens eine Gleichrichteranordnung (2) im Strompfad des Eingangs-(IE) und/oder des Ausgangsstromes (IA) umfaßt.

Fig. 1

EP 0 277 377 A1

## Schaltungsanordnung zur Bildung eines begrenzten Stromes

Die vorliegende Erfindung bezieht sich auf eine Schaltungsanordnung zur Bildung eines in seiner Größe auf einen durch wenigstens einen Grenzwert berandeten Aussteuerungsbereich begrenzten Ausgangsstromes aus einem Eingangsstrom.

Aus der Internationalen Patentanmeldung mit der internationalen Veröffentlichungsnummer WO 83/04351 sind ein Strombegrenzer und eine zugehörige Methode zum Begrenzen des Stromes durch einen Transistor bekannt, der von einer vorgeschalteten Verstärkerstufe betrieben wird. Der dort beschriebene Strombegrenzer umfaßt einen zusätzlichen Transistor, dessen Basis-und Emitteranschluß mit dem Basis-bzw. Emitteranschluß des Transistors verbunden ist, dessen Strom begrenzt werden soll. Eine Stromquelle speist einen vorgegebenen Strom in den Kollektor des zusätzlichen Transistors. Der zusätzliche Transistor gelangt in die Sättigung, wenn eine begrenzende Schwelle dadurch erreicht wird, daß die Größe des Treiberstromes, der den Basisanschlüssen der beiden Transistoren zugeführt wird, einen Wert überschreitet, in dem die Stromquelle nicht mehr den Kollektorstrom liefern kann, der vom zusätzlichen Transistor benötigt wird.

Durch die Aufteilung des zu begrenzenden Stromes von der voraufgehenden Verstärkerstufe auf die Basisanschlüsse der beiden Transistoren tritt zum einen eine Schwächung des zu begrenzenden Stromes und zum anderen eine durch Toleranzen der Bauelemente hervorgerufene Streuung im Aufteilungs verhältnis und damit im Übertragungsverhältnis auf. Ins besondere bei stark unterschiedlich dimensionierten Transistoren wirken sich diese Toleranzen beträchtlich aus. Darüberhinaus beeinflußt der in die Sättigung geratende zusätzliche Transistor die Übertragung des zu begrenzenden Stromes ungünstig. So bilden die im Fall der Sättigung in den zusätzlichen Transistor fließenden Ladungen eine kaum kontrollierbare Parallelkapazität, die das Übertragungsverhalten insbesondere bei höherfrequenten Strömen verschlechtert. Bei einer Integration des gesamten Strombegrenzers auf einem Halbleiterplättchen treten darüberhinaus unkontrollierte Substratströme auf, wenn einer der integrierten Transistoren in die Sättigung gerät. Dadurch kann das Verhalten der gesamten integrierten Schaltung unbestimmt werden.

Die Erfindung hat die Aufgabe, eine Schaltungsanordnung der eingangs genannten Art zu - schaffen, die eine Begrenzung auch hochfrequenter Ströme ermöglicht, ohne daß dabei - etwa durch Aufteilungen der zu begrenzenden Ströme oder durch Sättigungseffekte in den verwendeten Halbleiterbauelementen - Signalverzerrungen auftreten.

Die Aufgabe wird bei einer gattungsgemäßen Schaltungsanordnung nach der Erfindung durch ein Stromverknüpfungselement zur Bildung einer wenigstens nahezu linearen Kombination des Eingangsstromes, des Ausgangsstromes und eines festen Referenzstromes sowie durch wenigstens eine Gleichrichteranordnung im Strompfad des Eingangs-und/oder des Ausgangsstromes gelöst.

Der erfindungsgemäßen Schaltungsanordnung liegt die Erkenntnis zugrunde, daß zunächst eine lineare Abhängigkeit eines Ausgangsstromes von einem Eingangsstrom dadurch erreicht werden kann, daß eine Linearkombination dieser beiden Ströme gleich einer Konstanten, d. h. einer festen Referenz, gesetzt wird. In dem Maße, in dem dann der Eingangsstrom variiert wird, verändert sich mit umgekehrtem Vorzeichen linear auch der Ausgangsstrom. Wird nun die Richtung des Eingangs-oder des Ausgangsstromes festgelegt, ist damit der Wertebereich auch des jeweils anderen Stromes einseitig eingegrenzt. Eine derartige Strombegrenzung kann lediglich durch Verwendung einer Konstantstromquelle für den festen Referenzstrom und einer Gleichrichteranordnung für einen der beiden anderen Ströme erreicht werden. Dabei tritt weder eine Aufteilung des Eingangsstromes noch ein Sättigungseffekt in den Bauteilen auf. Vielmehr erhält man eine sehr direkte, verzerrungsarme Übertragung vom Eingangsstrom auf den Ausgangsstrom, die auch für die Begrenzung sehr hochfrequenter Signalströme geeignet ist.

Die erfindungsgemäße Schaltungsanordnung kann damit bevorzugt Verwendung finden in Signalbegrenzerschaltungen, Synchronsignalabtrennschaltungen, Rauschunterdrückungsschaltungen in Kammfiltern oder Schaltungen für nichtlineare Pre-und Deemphasis für die Videosignalverarbeitung in Videorecordern. Bei derartigen Anordnungen, die bisher in der Regel mit Spannungsaussteuerung betrieben wurden, kann eine Erhöhung der verarbeitbaren Signalfrequenz bei gleichzeitiger Verringerung des Strombedarfes und der Versorgungsspannung durch eine Stromaussteuerung anstelle der Spannungsaussteuerung erreicht werden. Damit lassen sich Schaltungsanordnungen zur Verarbeitung von Signalen auch sehr geringer Signalspannungen vorteilhaft aufbauen.

Vorteilhaft können das Stromverknüpfungselement und die Gleichrichteranordnung von einer Stromspiegelanordnung umfaßt werden, in deren erstem Stromzweig ein Teil und in deren zweitem Stromzweig die übrigen der eine wenigstens nahezu lineare Kombination bildenden Ströme eingespeist werden. Damit können die Kombinationen der Ströme und ihre Flußrichtungen leicht den Anforderungen angepaßt werden, die durch Schaltungsteile entstehen, mit denen die Strombegrenzung zusammenwirken soll. Beispielsweise können über eine Stromspiegelanordnung leicht Referenzströme eingespeist werden, die an anderen Stellen einer umfangreicheren Schaltung bereits für andere Zwecke benötigt und erzeugt werden. Besteht z. B. im einfachsten Fall eine derartige Stromspiegelanordnung aus zwei mit ihren Basisanschlüssen gekoppelten Transistoren, können die zu kombinierenden Ströme an den Kollektoranschlüssen dieser Transistoren eingespeist werden, wobei dann die Linearkombination dieser Ströme durch das starre Übersetzungsverhältnis der Kollektorströme der Transistoren und die Knotenpunktsregel an ihren Kollektoranschlüssen bei Einspeisung mehrerer Ströme an einem Kollektoranschluß gebildet wird. Die Basis-Emitter-Strecke eines der Transistoren dient dabei gleichzeitig als Gleichrichterschaltung.

Für eine mehrseitige Berandung des Aussteuerungsbereiches oder eine Begrenzung mehrerer Ströme werden vorteilhaft wenigstens ein weiteres Stromverknüpfungselement, eine weitere Gleichrichteranordnung und/oder ein weiterer Referenzstrom vorgesehen, wobei jedes Stromverknüpfungselement mit dem vorhergehenden über eine der Gleichrichteranordnungen verbunden ist. Beispielsweise kann eine zweiseitige Begrenzung des Aussteuerungsbereiches mit einer Anordnung erreicht werden, bei der sowohl der Eingangs-als auch der Ausgangsstrom über je eine Gleichrichteranordnung dem Stromverknüpfungselement zugeführt werden. Der gleiche Erfolg kann auch mit einer kettenförmigen Anordnung von mehreren Stromverknüpfungselementen und Gleichrichteranordnungen im Wechsel miteinander erreicht werden, wobei den Stromverknüpfungselementen wahlweise auch mehrere Eingangs-oder Ausgangsströme zugeführt werden können und darüber hinaus wahlweise auch jedem Stromverknüpfungselement ein Referenzstrom zugeleitet werden kann. Durch entsprechende Anordnung der Stromverknüpfungselemente und Gleichrichteranordnungen sowie Wahl der Referenzströme können die Aussteuerungsbereiche der Eingangs-und Ausgangsströme beliebig eingestellt werden. Da die Berandungen der Aussteuerungsbereiche unmittelbar den Referenzströmen entsprechen und alle Ströme über lineare Kombinationen verknüpft sind, kann daraus eine Auslegung und Dimensionierung der jeweils erforderlichen Schaltungsanordnung unmittelbar vorgenommen werden.

Bei einer Schaltungsanordnung mit mehreren Stromverknüpfungselementen ist vorteilhaft wenigstens eines davon mit dem vorhergehenden über eine wenigstens die Gleichrichteranordnung umfassende Stromspiegelanordnung verbunden. Dies ermöglicht neben den schon genannten Vorteilen der Stromspiegelanordnung beispielsweise eine einfache Stromrichtungsumkehr und damit Vorzeichenumkehr in der linearen Kombination der Ströme. Weiterhin können Eingangs-, Ausgangs- und Referenzströme über Stromspiegelanordnungen zur Entkopplung von außerhalb der Schaltungsanordnung der Strombegrenzung befindlichen Schaltungsteilen zugeführt bzw. abgeleitet werden.

In einer vorteilhaften Ausgestaltung umfaßt die erfindungsgemäße Schaltungsanordnung einen Transistor, dessen Basis-Emitter-Strecke eine der Gleichrichteranordnungen und dessen Kollektoranschluß das mit letzterer verbundene Stromverknüpfungselement bilden. Die dem Kollektoranschluß zugeführten Ströme überlagern sich dort linear nach der Kirchhoffschen Regel, wobei der über die Kollektor-Emitter-Strecke des Transistors geleitete Strom die durch den Transistor gebildete Gleichrichteranordnung durchfließt. Der Transistor kann - wie oben beschrieben - Teil eines in üblicher Weise aufgebauten Stromspiegels sein. Insgesamt entsteht dadurch ein sehr kompakter, einfacher Aufbau. Der Basisanschluß des Transistors kann beispielsweise mit dem Kollektoranschluß verbunden sein, so daß der Strom durch den Basisanschluß keine Verfälschung der Kombination der Ströme am als Stromverknüpfungselement dienenden Kollektoranschluß verursacht. Bei hinreichend hoher Verstärkung des Transistors und geringeren Anforderungen an die Genauigkeit der Ströme kann es auch vorteilhaft sein, dem Basisanschluß eine (feste) Referenzspannung zuzuführen.

Nach einer anderen Ausgestaltung umfaßt die erfindungsgemäße Schaltungsanordnung einen ersten Transistor, dessen miteinander verbundener Basis-und Kollektoranschluß ein erstes der Stromverknüpfungselemente und dessen Basis-Emitter-Strecke eine erste der Gleichrichteranordnungen bilden, sowie einen zweiten Transistor, dessen Kollektoranschluß ein zweites der Stromverknüpfungselemente und dessen Basis-Emitter-Strecke eine zweite der Gleichrichteranordnungen bilden, wobei die miteinander verbundenen Emitteranschlüsse des ersten und zweiten Transistors ein drittes der Stromverknüpfungselemente bilden, dem ersten Stromverknüpfungselement der Eingangsstrom und ein erster Referenzstrom, dem dritten Stromverknüpfungselement außer den Emitterströmen des ersten und zweiten Transistors ein dritter Referenzstrom und dem zweiten Stromverknüpfungselement ein zweiter Referenzstrom und der Ausgangsstrom zugeführt werden. Der erste und der zweite Transistor sind in der Art eines Differenzverstärkers mit zwei Stromzweigen miteinander verbunden und der Eingangsstrom wird dem ersten Zweig zugeführt, während der Ausgangsstrom dem zweiten Zweig entnommen wird. Dem Basisanschluß des zweiten Transistors wird vorzugsweise eine Referenzspan nung zugeführt, die einen Bezugspegel für die Zufuhr des Eingangsstromes liefert. Eine solche Anordnung bewirkt eine zweiseitige Begrenzung des Ausgangsstromes, wobei der erste Referenzstrom unmittelbar den unteren Grenzwert des Eingangsstromes, der dritte Referenzstrom den Aussteuerungsbereich des Ausgangsstromes und der zweite Referenzstrom den oberen Grenzwert des Ausgangsstromes bilden.

Gemäß einer Fortbildung der Erfindung ist wenigstens ein Stromverknüpfungselemt mit wenigstens einem einen Überschußstrom führenden Zweig verbunden. Ein solcher Überschußstrom wird vorteilhaft dann erzeugt, wenn in der Schaltungsanordnung ein Strom hervorgerufen wird, dem gemäß der vorgegebenen linearen Kombination ein Ausgangsstrom zugeordnet ist, dessen Wert außerhalb des Aussteuerungsbereiches liegt. Die Stromdifferenz, die den Wert übersteigt, der dem Grenzwert des Ausgangsstromes zugeordnet ist, wird dann als Überschußstrom von dem genannten Zweig geführt. Dadurch können beispielsweise Spannungsüberhöhungen an die Referenzströme liefernden Quellen und ähnliche Signalverzerrungen vermieden werden. Der Überschußstrom kann auch als (weiterer) Ausgangsstrom ausgenutzt werden, der dann in dem Aussteuerungsbereich des Eingangsstromes fließt, in dem der Ausgangsstrom begrenzt ist.

Jeder einen Überschußstrom führende Zweig umfaßt vorteilhaft einen Überschußstromtransistor, dessen Emitter mit dem Stromverknüpfungselement, dessen Kollektor mit einem Anschluß einer Stromversorgung und dessen Basis mit einer Referenzspannungsquelle verbunden ist. Wenn dann aufgrund einer Überschreitung eines Grenzwertes für einen Strom am Stromverknüpfungselement eine unerwünschte Spannungsveränderung auftritt, die eine durch die Referenzspannungsquelle vorgegebene Schwelle überschreitet, wird der Über schußstrom aus der Stromversorgung nachgeliefert und dadurch die Spannung am Stromverknüpfungselement nicht oder nur unwesentlich weiterverändert.

Die Referenzspannung kann vorteilhaft einer Anzapfung eines von der Referenzspannungsquelle umfaßten, zwischen dem Anschluß der Stromversorgung und Masse angeordneten ersten Widerstandsspannungsteilers entnommen werden, dem die Kollektor-Emitter-Strecke eines Transistors parallel geschaltet ist. Durch diese Anordnung wird eine niedrige Spannungsschwelle vorgegeben, so daß bereits bei geringen Veränderungen der Spannung am Stromverknüpfungselement der Überschußstrom zu fließen beginnt. Durch den Transistor wird ferner eine Kompensation der Temperaturabhängigkeit des Überschußstromtransistors erreicht. Der Basisanschluß des zum ersten Widerstandsspannungsteilers parallel geschalteten Transistors wird vorteilhaft entweder mit seinem Kollektoranschluß oder mit einem Abgriff eines zweiten Widerstandsspannungsteilers verbunden, der parallel zur Kollektor-Emitter-Strecke dieses Transistors angeordnet ist. Während im ersten Fall dem ersten Widerstandsspannungsteiler die Basis-Emitter-Strecke des Transistors parallel geschaltet und die Spannung am ersten Widerstandsspannungsteiler somit auf die Flußspannung der Basis-Emitter-Strecke festgelegt ist, kann im zweiten Fall die vom ersten Widerstandsspannungsteiler abgegriffene Referenzspannung dadurch unterschiedlichen Bedingungen angeglichen werden, daß der Widerstandswert des ersten Widerstandsspannungsteilers zwischen dem Kollektor-und dem Emitteranschluß des Transistors das Doppelte und der Widerstandswert des zwischen dem Kollektor-und dem Basisanschluß des Transistors angeordneten Teils des zweiten Widerstandsspannungsteilers das (N-1)-fache des Widerstandswertes des zwischen dem Basis-und dem Emitteranschluß des Transistors angeordneten Teils des zweiten Widerstandsspannungteilers betragen, wobei N größer oder gleich 1 ist.

Eine weitere Verbesserung der Kompensation der Temperaturabhängigkeit des Überschußstromtransistors kann dadurch erreicht werden, daß die Referenzspannung der Referenzspannungsquelle über die Basis-Emitter-Strecke eines Kompensationstransistors entnommen wird. Auf diese Weise ist zwischen dem Stromverknüpfungselement und der Referenzspannungsquelle eine Reihenschaltung zweier Basis-Emitter-Strecken angeordnet, wobei die über diesen Strecken abfallenden Spannungen einander aufheben. Damit entfällt auch die durch temperaturbedingte Veränderungen dieser Spannungen hervorgerufene Temperaturabhängigkeit in der Arbeitsweise des den Überschußstrom abgebenden Zweiges.

Eine entsprechende Kompensation kann nach einer anderen Fortbildung der Erfindung auch dadurch erzielt werden, daß die Referenzspannungsquelle einen Transistor umfaßt, dessen Basis-Emitter-Strecke eine in Flußrichtung gepolte erste Diode parallel geschaltet und dessen Kollektor-Emitter-Strecke in Reihe mit einem mit dem Kollektoranschluß verbundenen Widerstand angeordnet ist, wobei der Basisanschluß des Transistors mit einem Abgriff des Widerstandes verbunden ist und die Referenzspannung dem Kollektoranschluß entnommen wird. Der Basisanschluß des Transistors kann unmittelbar oder über eine in Flußrichtung gepolte zweite Diode mit dem Abgriff des Widerstandes verbunden sein. Eine solche Anordnung stellt einen Stromspiegel mit einem durch die erste und gegebenenfalls die zweite Diode gebildeten ersten Zweig und einem durch den zwischen dem Abgriff und dem Kollektor des Transistors angeordneten Teil des Widerstandes sowie die Kollektor-Emitter-Strecke des Transistors gebildeten zweiten Zweig dar. Der Strom durch die Dioden legt über den Transistor auch den Strom durch den Widerstand und damit den Spannungsabfall an diesem fest, während die Temperaturkompensation durch eine gegensinnige Überlagerung der Spannung an der ersten Diode bzw. der Basis-Emitter-Strecke des Transistors einerseits und der Basis-Emitter-Strecke des Überschußstromtransistors andererseits erreicht wird.

Einige Ausführungsbeispiele der Erfindung sind in der Zeichnung dargestellt und werden im nachfolgenden näher erläutert. Es zeigen

Fig. 1 ein Prinzipschaltbild der Erfindung,

Fig. 2 ein Ausführungsbeispiel einer Schaltungsanordnung gemäß Fig. 1,

Fig. 3 ein Diagramm mit Strom-und Spannungsverläufen zur Schaltungsanordnung nach Fig. 2,

Fig. 4 das Prinzipschaltbild einer weiteren Ausführungsform der Erfindung und

Fig. 5 das Schaltbild einer Anordnung zur Strombegrenzung gemäß Fig. 4,

Fig. 6 ein Diagramm mit Strom-und Spannungsverläufen zur Schaltungsanordnung nach Fig. 5,

Fig. 7 das Prinzipschaltbild eines weiteren Ausführungsbeispieles der Erfindung,

Fig. 8 eine Schaltungsanordnung zur Realisierung des Prinzips nach Fig. 7,

Fig. 9 ein Diagramm mit Strom-und Spannungsverläufen in der Schaltungsanordnung nach Fig. 8,

Fig. 10 bis 14 verschiedene Weiterbildungen der Schaltungsanordnung nach Fig. 8.

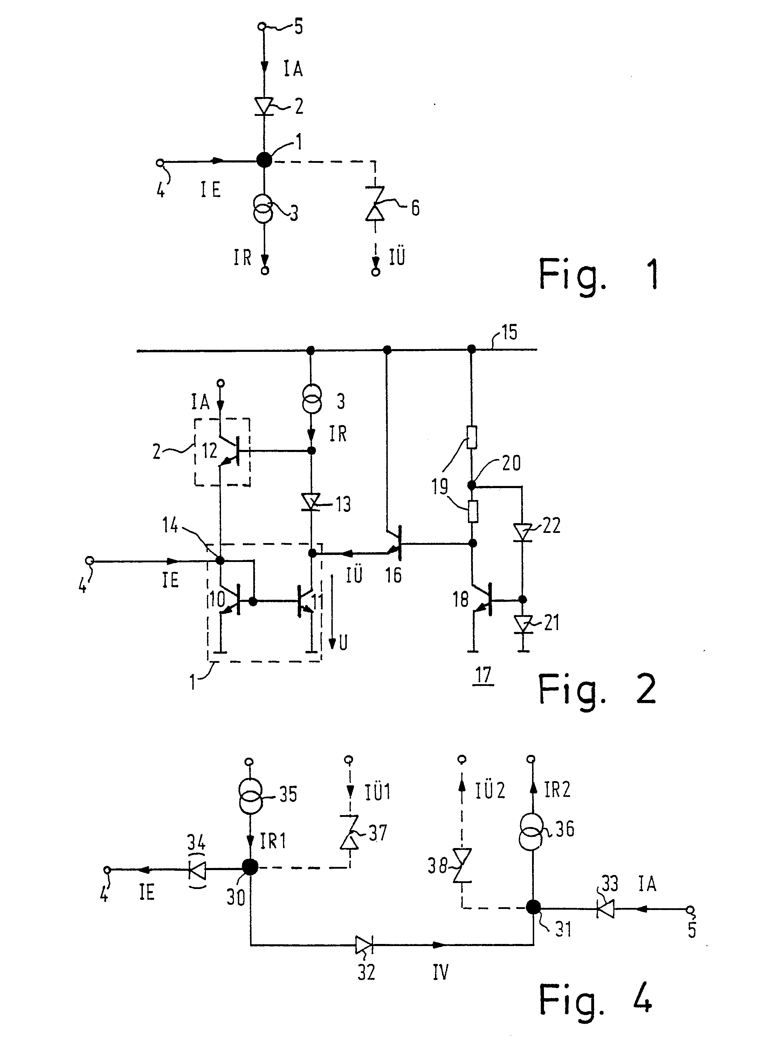

Die Fig. 1 zeigt ein einfaches Prinzipschaltbild für eine erfindungsgemäße Schaltungsanordnung, in der ein Knotenpunkt 1 ein Stromverknüpfungselement und eine Diode 2 eine Gleichrichteranordnung bilden. Von einer Stromquelle 3 wird ein fester Referenzstrom IR geliefert. Von einem Eingangsanschluß 4 fließt ein Eingangsstrom IE und von einem Ausgangsanschluß 5 ein Ausgangsstrom IA in den Knotenpunkt 1, letzterer über die Diode 2. Die Polung der Diode 2 kann auch umgekehrt werden, so daß der Ausgangsstrom IR vom Knotenpunkt 1 zum Ausgangsanschluß 5 fließt. Ebenso kann die positive Bezugsrichtung für den Eingangsstrom IE umgekehrt werden. In jedem Fall erhält man am Knotenpunkt 1 eine lineare Kombination der beiden Ströme, in die nach der Kirchhoffschen Regel auch der Referenzstrom IR einbezogen ist. In dem Maße, in dem sich nun der Eingangsstrom IE ändert, ändert sich mit umgekehrtem Vorzeichen auch der Ausgangsstrom IA, da die lineare Kombination der drei Ströme nach der Kirchhoffschen Regel stets 0 ergeben muß. Als Randbedingung für diese Veränderungen wird von der Diode 2 erzwungen, daß der Ausgangsstrom IA nicht negativ werden kann. Das bedeutet, daß der Eingangsstrom IE höchstens den Wert des Referenzstromes IR annehmen kann. Es wird so eine einfache Begrenzung der Aussteuerungsbereiche für Eingangs-und Ausgangsstrom IE bzw. IA geschaffen, die unabhängig von jeder Art von Stromverzweigungen oder Sättigungseffekten sehr direkt arbeitet und damit auch für sehr hochfrequente Ströme geeignet ist.

Die Fig. 1 zeigt weiterhin einen mit dem Knotenpunkt 1 verbundenen, gestrichelt gezeichneten Zweig, der symbolisch mit einer Zehnerdiode 6 dargestellt ist und einen Überschußstrom IÜ führt, wenn der Eingangsstrom IE von einer mit dem Eingangsanschluß 4 verbundenen und nicht dargestellten Schaltung auf einen Wert gezwungen wird, der den vorstehend beschriebenen, durch die Diode 2 hervorgerufenen Grenzwert überschreitet. In einem solchen Fall steigt bei der Schaltungsanordnung nach Fig. 1 die Spannung am Knotenpunkt 1 unter Voraussetzung einer idealen Diode 2 und einer idealen Stromquelle 3 gegen unendlich, wenn kein Zweig für einen Überschußstrom IÜ vorgesehen ist. Bei einem derartigen Spannungsanstieg wird die Zehnerdiode 6 leitend und führt den den Grenzwert überschreitenden Strom ab.

Fig. 2 zeigt ein Beispiel für eine Schaltungsanordnung zur Strombegrenzung nach dem in Fig. 1 dargestellten Prinzip. Die Schaltungsanordnung umfaßt einen Stromspiegel üblicher Bauart aus einem ersten, zweiten und dritten Stromspiegeltransistor 10, 11 bzw. 12 und einer Stromspiegeldiode 13, die im wesentlichen nur zur Potentialeinstellung dient und in einer Abwandlung der dargestellten Schaltungsanordnung auch entfallen kann. Die Kollektor-Emitter-Strecken des ersten und des dritten Stromspiegeltransistors 10 bzw. 12 sind miteinander in Reihe geschaltet und bilden einen ersten Stromzweig, während die Kollektor-Emitter-Strecke des zweiten Stromspiegeltransistors 11 in Reihe mit der Stromspiegeldiode 13 einen zweiten Stromzweig bildet.In diesen wird von der Stromquelle 3 der Referenzstrom IR und am Verbindungspunkt zwischen der Stromspiegeldiode 13 und dem zweiten Stromspiegeltransistor 11 gegebenenfalls der Überschußstrom IÜ eingespeist, während im ersten Stromzweig im dritten Stromspiegeltransistor 12 der Ausgangsstrom IA fließt und über den Eingangsanschluß 4 der Eingangsstrom IE dem Verbindungspunkt 14 zwischen dem Emitteranschluß des dritten Stromspiegeltransistors 12 und dem Kollektoranschluß des ersten Stromspiegeltransistors 10 eingespeist wird.

Der Kern des Stromspiegels 10, 11, 12, (und 13), der durch den ersten und zweiten Stromspiegeltransistor 10 bzw. 11, deren Basisanschlüsse miteinander verbunden sind, gebildet wird, übernimmt zusammen mit dem Verbindungspunkt 14 die Funktion des Stromverknüpfungselementes 1. Darin werden der Referenzstrom IR und gegebenenfalls der Überschußstrom IÜ vom zweiten Stromspiegeltransistor 11 auf den ersten Stromspiegeltransistor 10 gespiegelt und am Verbindungspunkt 14 mit dem Eingangs-und dem Ausgangsstrom IE bzw. IA gemäß der Kirchhoffschen Regel in einer linearen Kombination überlagert. Die Funktion der Gleichrichteranordnung 2 wird von der Basis-Emitter-Strecke des dritten Stromspiegeltransistors 12 übernommen, der den Ausgangsstrom IA führt.

Der Überschußstrom IÜ wird vom positiven Anschluß einer Stromversorgung 15 über einen durch die Kollektor-Emitter-Strecke eines Überschußstromtransistors 16 gebildeten Zweig abgeleitet und dem Stromverknüpfungselement 1 zugeführt. Der Basisanschluß des Überschußstromtransistors 16 ist mit einer Referenzspannungsquelle 17 verbunden, die einen Transistor 18, einen Widerstand 19 mit Abgriff 20 sowie eine erste und eine zweite Diode 21 bzw. 22 umfaßt. Widerstand 19 und Kollektor-Emitter-Strecke des Transistors 18 bilden eine zwischen dem positiven Anschluß der Stromversorgung 15 und Masse angeordnete Reihenschaltung, während die erste Diode 21 parallel zur Basis-Emitter-Strecke des Transistors 18 und die zweite Diode 22 zwischen den Abgriff 20 und den Basisanschluß des Transistors 18 geschaltet ist.

Im Diagramm in Fig. 3 sind der Ausgangsstrom IA und der Überschußstrom IÜ sowie mit anderem Maßstab die Spannung U am Kollektor des zweiten Stromspiegeltransistors 11 gegenüber Masse in Abhängigkeit vom Eingangsstrom IE aufgetragen. Durch die Schraffur unterhalb der Abszisse ist die Begrenzung des Aussteuerungsbereiches für den Ausgangsstrom IA auf positive Werte angedeutet, die durch die Gleichrichteranordnung 2 bedingt ist. Dieser Begrenzung entspricht eine Begrenzung des Eingangsstromes IE auf einen Maximalwert IR, oberhalb dessen der Ausgangsstrom IA konstant (auf dem Wert 0) verbleibt, während ein Eingangsstrom IE mit erzwungenem höheren Wert durch den Überschußstrom IÜ abgeleitet wird.

Solange der Eingangsstrom IE kleiner ist als der Referenzstrom IR, ist die Spannung U über der Kollektor-Emitter-Strecke des zweiten Stromspiegeltransistors 11 gegenüber der von der Referenzspannungsquelle 17 dem Basisanschluß 16 des Überschußstromtransistors zugeführten Referenzspannung so groß, daß der Überschußstromtransistor 16 gesperrt ist und kein Überschußstrom IÜ fließen kann. Erreicht jedoch der Eingangsstrom IE den Wert des Referenzstromes IR, sinkt die Spannung soweit unter die Referenzspannung ab, daß der Überschußstromtransistor 16 leitend wird und der Überschußstrom IÜ zu fließen beginnt. Dieses Verhalten ist als Absatz in der Spannungskurve deutlich zu erkennen.

Da die Strom-Spannungs-Kennlinie der Basis-Emitter-Strecke des Überschußstromtransistors eine starke Temperaturabhängigkeit aufweist, kann sich bei einer temperaturunabhängigen Referenzspannung am Basisanschluß des Überschußstromtransistors 16 der Wert des Eingangsstromes IE, bei dem der Überschußstrom IÜ zu fließen beginnt, mit der Temperatur verändern und damit ein unerwünschtes Verhalten der Schaltunganordnung hervorrufen. Die Referenzspannungsquelle ist daher so ausgebildet, daß die Temperaturabhängigkeit des Überschußstromtransistors 16 kompensiert wird. Die Dioden 21, 22 einerseits und der Teil des Widerstandes 19 zwischen dem Abgriff 20 und dem Kollektor des Transistors 18 sowie die Kollektor-Emitter-Strecke dieses Transistors andererseits bilden die zwei Stromzweige eines Stromspiegels. Der Strom im ersten, durch die Dioden 21,22 gebildeten Zweig wird durch die Spannung am positiven Anschluß der Stromversorgung 15 und den zwischen diesem und dem Abgriff 20 angeordneten Teil des Widerstandes 19 bestimmt. Aus dem ersten Stromzweig wird dieser Strom in den zweiten Stromzweig, d. h. die Kollektor-Emitter-Strecke des Transistors 18 gespiegelt und erzeugt am Teil des Widerstandes 19 zwischen dem Abgriff 20 und dem Basisanschluß des Überschußstromtransistors 16 einen konstanten Spannungsabfall. Durch den Einfluß der variierenden Temperatur verändern sich nun die Spannungen über den Dioden 21, 22, durch die die gleichsinnigen Spannungsvariationen am zweiten Stromspiegeltransistor 11 und der Basis-Emitter-Strecke des Überschußstromtransistors 16 kompensiert werden.

Fig. 4 zeigt das Prinzipschaltbild einer weiteren Ausführungsform der Erfindung. Sie umfaßt ein erstes und ein zweites Stromverknüpfungselement 30, 31, dargestellt durch zwei Knotenpunkte, die über eine erste Gleichrichteranordnung 32, dargestellt durch eine Diode, verbunden sind. Vom Eingangsanschluß 4 wird der Eingangsstrom IE in den ersten Knotenpunkt 30 eingespeist. Im vorliegenden Beispiel ist die positive Stromrichtung des Eingangsstromes IE vom ersten Knotenpunkt 30 zum Eingangsanschluß 4 hin gewählt. Dem ersten Knotenpunkt 30 wird weiterhin aus einer ersten Stromquelle 35 ein erster Referenzstrom IR1 sowie gegebenenfalls aus einem ersten Zweig ein erster Überschuß strom IÜ1 zugeleitet. Der Zweig für den Überschußstrom IÜ1 ist symbolisch durch eine erste Zehnerdiode 37 dargestellt. Entsprechend werden im zweiten Knotenpunkt 31, der vom Ausgangsanschluß 5 über eine zweite Gleichrichteranordnung 33 zugeführte Ausgangsstrom IA, ein zweiter Referenzstrom IR2 aus einer zweiten Stromquelle 36 sowie gegebenenfalls ein in einem zweiten Zweig - dargestellt durch eine zweite Zehnerdiode 38 - geführter zweiter Überschußstrom IÜ2 miteinander verknüpft. Vom ersten zum zweiten Knotenpunkt fließt durch die erste Gleichrichteranordnung 32 ein Verbindungsstrom IV.

Solange der Eingangsstrom IE kleiner ist als der erste Referenzstrom IR1, fließt durch die erste Gleichrichteranordnung 32 ein Verbindungsstrom IV, der der Differenz aus dem ersten Referenzstrom IR1 und dem Eingangsstrom IE entspricht. Überschreitet der Eingangsstrom IE den ersten Referenzstrom IR1, führt der erste Zweig (erste Zehnerdiode 37) den ersten Überschußstrom IÜ1, während der Verbindungsstrom IV konstant gleich Null bleibt. Andererseits ist der Wert des Verbindungsstromes IV in Richtung auf eine Verkleinerung des Eingangsstromes IE auch zu negativen Werten hin durch die erste Gleichrichteranordnung 32 nicht begrenzt.

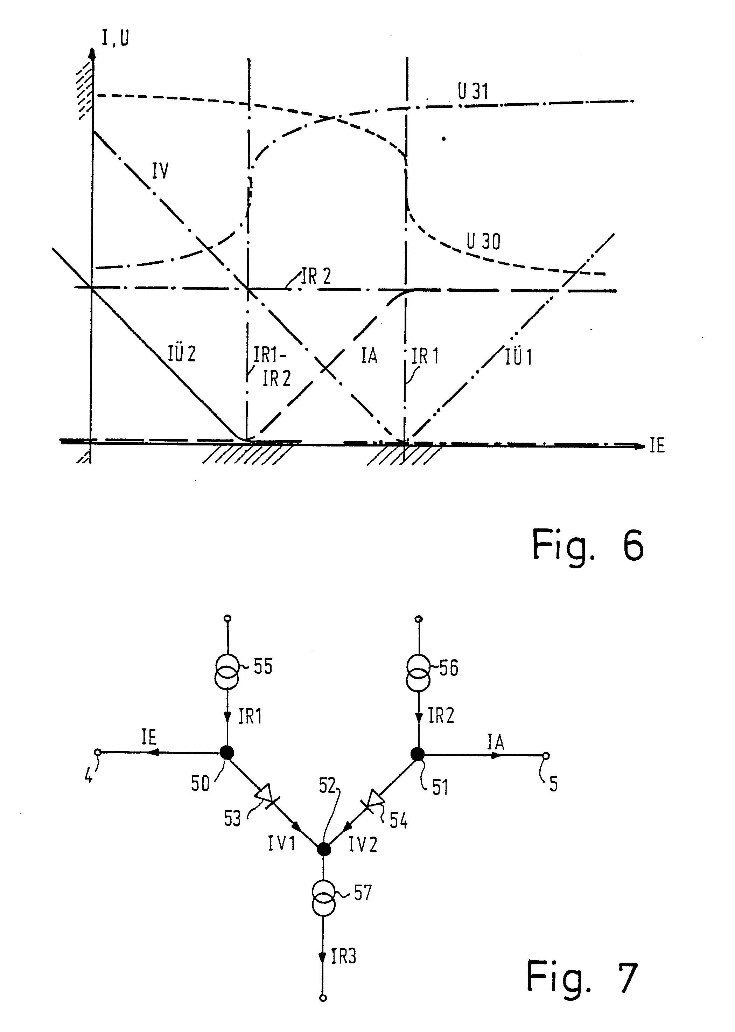

Am zweiten Knotenpunkt 31 wird aus der Differenz des zweiten Referenzstromes IR2 und des auf positive Werte begrenzten Verbindungsstromes IV der Ausgangsstrom IA gebildet, der durch die zweite Gleichrichteranordnung 33 seinerseits auf positive Werte begrenzt ist. Dabei ändern sich der Verbindungsstrom IV und der Ausgangsstrom IA gegensinnig. Übersteigt der Verbindungsstrom IV den zweiten Referenzstrom IR2, wird der Ausgangsstrom IA gleichbleibend zu 0 und überschüssiger Verbindungsstrom IV fließt über den zweiten Zweig (zweite Zehnerdiode 38) als zweiter Überschußstrom IÜ2 ab. Insgesamt resultiert ein Ausgangsstrom IA, der auf einen Aussteuerungsbereich zwischen dem Wert 0 und IR2 begrenzt ist. Die beschriebenen Ströme sind im Diagramm in Fig. 6 als Funktionen des Eingangsstromes IE aufgetragen.

Die Schaltungsanordnung nach Fig. 4 enthält wahlweise eine dritte Gleichrichteranordnung 34 zwischen dem ersten Knotenpunkt 30 und dem Eingangsanschluß 4. Dadurch wird der Aussteuerungsbereich für den Eingangsstrom IE auf positive Stromwerte begrenzt. Je nach Wahl der Werte für die Referenzströme IR1 und IR2, die den Aussteuerungsbereich bestimmen, in dem Eingangs- und Ausgangsstrom linear voneinander abhängen, kann dadurch eine weitere Strombegrenzung erreicht werden, die diesen Aussteuerungsbereich gegebenenfalls stärker einengt als die Gleichrichteranordnungen 32 und 33. Im Diagramm nach Fig. 6 wirkt sich die Begrenzung des Eingangsstromes IE jedoch nicht auf den Aussteuerungsbereich des Ausgangsstromes IA aus, da IR1 größer gewählt ist als IR2.

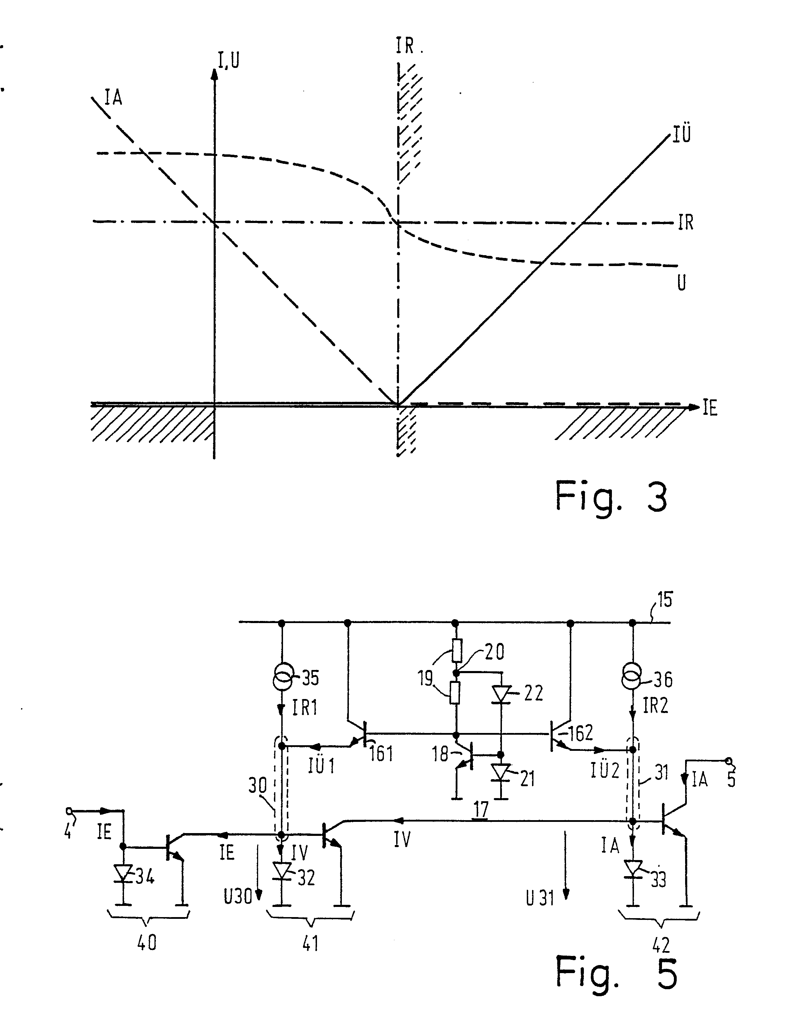

Fig. 5 zeigt ein Beispiel für eine Schaltunganordnung zur praktischen Ausführung des in Fig. 4 gezeigten Prinzips. Darin sind bereits beschriebene Elemente oder solchen entsprechende Elemente wieder mit denselben Bezugzeichen versehen. Der Eingangsstrom IE wird vom Eingangsanschluß 4 über einen ersten Stromspiegel 40, der eine Entkopplung des Eingangsanschlusses 4 und eine Richtungsumkehr des Eingangsstromes IE bewirkt, dem ersten Knotenpunkt 30 zugeleitet. Darin wird eine lineare Kombination des Eingangsstromes IE mit dem ersten Referenzstrom IR1 aus der ersten Stromquelle 35 und gegebenenfalls dem ersten Überschußstrom IÜ1 zum Verbindungsstrom IV vorgenommen. Dieser wird weiter über einen zweiten Stromspiegel 41 dem zweiten Knotenpunkt 31 zugeleitet und darin mit dem zweiten Refe renzstrom IR2 und gegebenenfalls dem zweiten Überschußstrom IÜ2 zum Ausgangsstrom IA verknüpft. Der Ausgangsstrom IA wird über einen dritten Stromspiegel 42 an den Ausgangsanschluß 5 gespiegelt. Die Stromspiegel 41, 42, die wie der Stromspiegel 40 aus je einer Diode und einem Transistor bestehen, bilden mit ihren Dioden die Gleichrichteranordnungen 32 und 33 (und wahlweise 34) und mit ihren Verbindungspunkten zwischen je dem Basisanschluß des zugehörigen Transistors und der Diode die Stromverknüpfungselemente 30, 31 (Knotenpunkte). Bei hoher Verstärkung der Transistoren sind deren Kollektorströme im wesentlichen gleich den Strömen in den zugehörigen Dioden, so daß Übertragungsfehler gering gehalten werden.

Die Überschußströme IÜ1 und IÜ2 werden aus dem positiven Anschluß der Stromversorgung 15 über einen ersten bzw. einen zweiten Überschußstromtransistor 161, 162 den Knotenpunkten 30 bzw. 31 zugeführt. Den Basisanschlüssen der Überschußstromtransistoren 161, 162 wird eine Referenzspannung zugeleitet, die in einer Referenzspannungsquelle 17 erzeugt wird, die mit derjenigen aus Fig. 2 identisch ist.

Im Stromdiagramm von Fig. 6 sind mit verändertem Maßstab auch die Spannungen U30 und U31 an den Knotenpunkten 30 bzw. 31 in Abhängigkeit vom Eingangsstrom IE aufgetragen. Jede von ihnen weist den anhand Fig. 3 beschriebenen Spannungssprung auf, der mit dem Einsetzen des zugehörigen Überschußstromes IÜ1 bzw. IÜ2 verknüpft ist.

In Fig. 6 ist der Wert für den ersten Referenzstrom IR1 gleich dem doppelten des Wertes des zweiten Referenzstromes IR2. Durch Wahl anderer Werte für die Referenzströme lassen sich die Aussteuerungsbereiche für den Eingangs-und den Ausgangsstrom nach Wunsch verändern. Dabei kann auch der Gleichstromwert, um den die Werte des Ausgangsstromes IA gegenüber den Werten des Eingangsstromes IE im Bereich der linearen Abhängigkeit zwischen beiden Strömen verschoben sind, nach Belieben angepaßt werden.

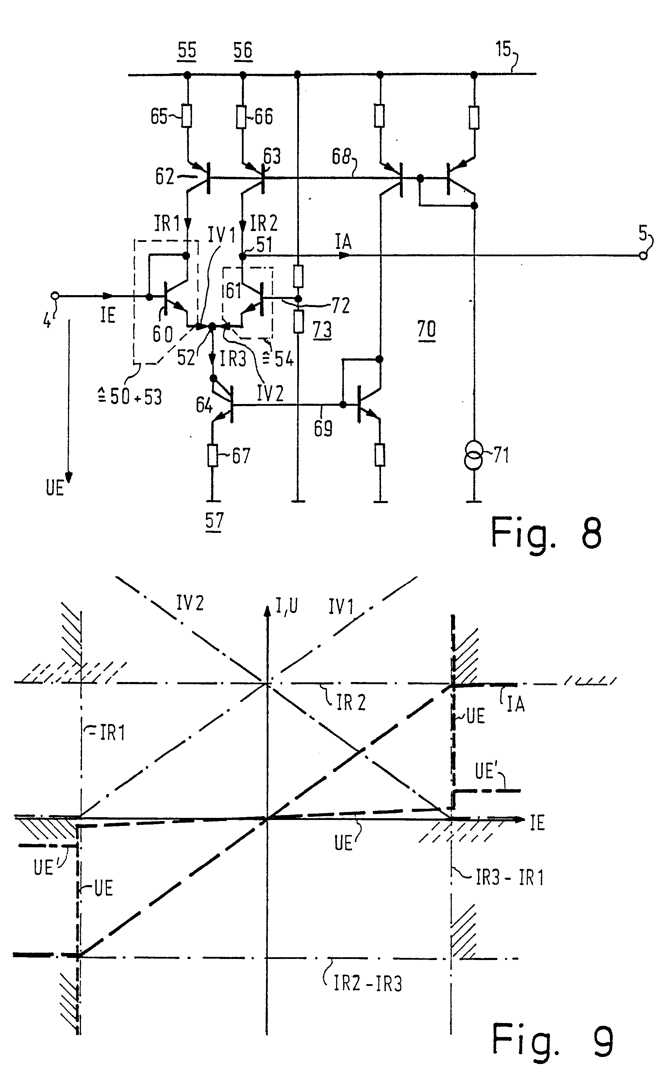

Fig. 7 zeigt das Prinzipschaltbild einer anderen Ausführungsform der Erfindung, in der ein erster, ein zweiter und ein dritter Knotenpunkt 50, 51, 52, die je ein Stromverknüpfungselement bilden, über eine erste bzw. eine zweite Gleichrichteranordnung 53 bzw. 54 paarweise miteinander verbunden sind. Im ersten Knotenpunkt 50 werden der Eingangsstrom IE und ein erster Referenzstrom IR1 von einer ersten Stromquelle 55 zu einem ersten Verbindungsstrom IV1 linear kombiniert, der durch die erste Gleichrichteranordnung 53 dem dritten Knotenpunkt 52 zufließt. Entsprechend werden im zweiten Knotenpunkt 51 ein zweiter Referenzstrom IR2 aus einer zweiten Stromquelle 56 mit dem zum Ausgangsanschluß 5 fließenden Ausgangsstrom IA zu einem zweiten Verbindungsstrom IV2 kombiniert und dieser im dritten Knotenpunkt 52 mit dem ersten Verbindungsstrom IV1 und einem dritten Referenzstrom IR3 von einer dritten Stromquelle 57 verknüpft. Der erste Knotenpunkt 50 und die erste Gleichrichteranordnung 53 begrenzen zusammen den Eingangsstrom IE auf einen Aussteuerungsbereich oberhalb des negativen Wertes des ersten Referenzstromes IR1. Entsprechend begrenzt die zweite Gleichrichteranordnung 54 in Verbindung mit dem ersten und dem dritten Referenzstrom IR1 und IR3 und dem ersten Knotenpunkt 50 den Aussteuerungsbereich des Eingangsstromes IE zu positiven Werten hin auf einen Wert, der der Differenz IR3-IR1 des dritten und des ersten Referenzstromes entspricht. Durch Zusammenwirken des zweiten Referenzstromes IR2 von der zweiten Stromquelle und der zweiten Gleichrichteranordnung 54 über den zweiten Knotenpunkt 51 wird der Ausgangsstrom IA zusätzlich in seinem Aussteuerungsbereich auf Werte kleiner als der zweite Referenzstrom IR2 begrenzt. In Fig. 9 sind die beschriebenen Ströme als Funktionen des Eingangsstromes IE in einem Diagramm aufgetragen, und zwar für den Sonderfall, daß der erste und der zweite Referenzstrom IR1 und IR2 übereinstimmen und halb so groß sind wie der dritte Referenzstrom IR3. Durch veränderte Wahl der Referenzströme lassen sich auch hier die Aussteuerungsbereiche variieren.

Fig. 8 zeigt eine detaillierte Ausführungsform einer Anordnung gemäß dem Prinzip nach Fig. 7. Bereits erläuterte Bestandteile sind wieder mit den gleichen Bezugszeichen versehen. Die Schaltungsanordnung umfaßt einen ersten und einen zweiten Transistor 60 bzw. 61, deren Emitter miteinander in der Art eines Differenzverstärkers im Knotenpunkt 52 verbunden sind. Vom Eingangsanschluß 4 wird dem ersten Transistor 60 an seinem Basisanschluß der Eingangsstrom IE zugeführt, während am Kollektoranschluß der erste Referenzstrom IR1 eingespeist wird. Basis-und Kollektoranschluß sind miteinander verbunden. Der erste Transistor 60 übernimmt damit einerseits die Funktion des ersten Knotenpunktes 50 und mit seiner Basis-Emitter-Strecke andererseits die Funktion der ersten Gleichrichteranordnung 53. Von seinem Emitteranschluß fließt der erste Verbindungsstrom IV1 dem dritten Knotenpunkt 52 zu.

Der Kollektoranschluß des zweiten Transistors 61 ist mit dem zweiten Knotenpunkt 51 verbunden, an dem der zweite Referenzstrom IR2 und der Ausgangsstrom IA2 zum zweiten Verbindungsstrom IV2 kombiniert werden, der vom Emitteranschluß des zweiten Transistors 61 dem dritten Knotenpunkt 52 zugeleitet wird, an dem außerdem der dritte Referenzstrom IR3 eingespeist wird.

Die Stromquellen 55, 56, 57 werden durch je einen Stromquellentransistor 62, 63, bzw. 64 gebildet, zu deren Kollektor-Emitter-Strecke zusätzlich je ein Stromquellenwiderstand 65, 66 bzw. 67, verbunden mit dem Emitteranschluß des zugehörigen Stromquellentransistors 62, 63 bzw. 64, in Reihe geschaltet ist. Der erste und der zweite Stromquellentransistor 62, 63 werden an ihren Basisanschlüssen über eine gemeinsame erste Steuerleitung 68 und der dritte Stromquellentransistor 64 wird über eine zweite Steuerleitung 69 aus einem Referenzstromspiegel 70 von einer gemeinsamen Bezugsstromquelle 71 gesteuert. Zur Erzielung eines im Vergleich zum ersten und zweiten Referenzstrom IR1 bzw. IR2 verdoppelten dritten Referenzstromes IR3 sind die Halbleiterübergangsflächen des dritten Stromquellentransistors 64 gegenüber denen des ersten und zweiten Stromquellentransistors 62 bzw. 63 verdoppelt, was in der Fig. 8 durch zwei Kollektoranschlüsse symbolisiert ist.

Der Basisanschluß des zweiten Transistors 61 ist mit dem Abgriff 72 eines Widerstandsspannungsteilers 73 verbunden, der zwischen den positiven Anschluß der Stromversorgung 15 und Masse geschaltet ist, so daß der Basisanschluß des zweiten Transistors 61 auf einem festen Spannungspotential liegt.

Im Stromdiagramm der Fig. 9 ist weiterhin mit verändertem Maßstab die Eingangsspannung UE zwischen dem Eingangsanschluß 4 und Masse in Abhängigkeit vom Eingangsstrom IE aufgetragen. Dabei ist der Wert, den die Eingangsspannung UE bei Verschwinden des Eingangsstromes IE annimmt, in den Nullpunkt des Stromdiagrammes gelegt. Die Spannung UE variiert im Aussteuerungsbereich des Eingangsstromes IE nur geringfügig, bei Erreichen einer der Strombegrenzungen steigt sie jedoch steil an. Diese starke Spannungserhöhung macht sich insbesondere bei hohen Frequenzen dadurch nachteilig bemerkbar, daß durch sie die unvermeidlichen parasitären Kapazitäten insbesondere des ersten Transistors 60 stark umgeladen werden. Um die dadurch bedingten Beschränkungen des Amplituden-Frequenzgangs der Schaltungsanordnung zu vermeiden, ist es erstrebenswert, diese Spannungsüberhöhungen zu beseitigen. Erstrebenswert wäre beispielsweise ein Verlauf, wie er in Fig. 9 durch die mit UE' bezeichneten Kurvenäste wiedergegeben ist.

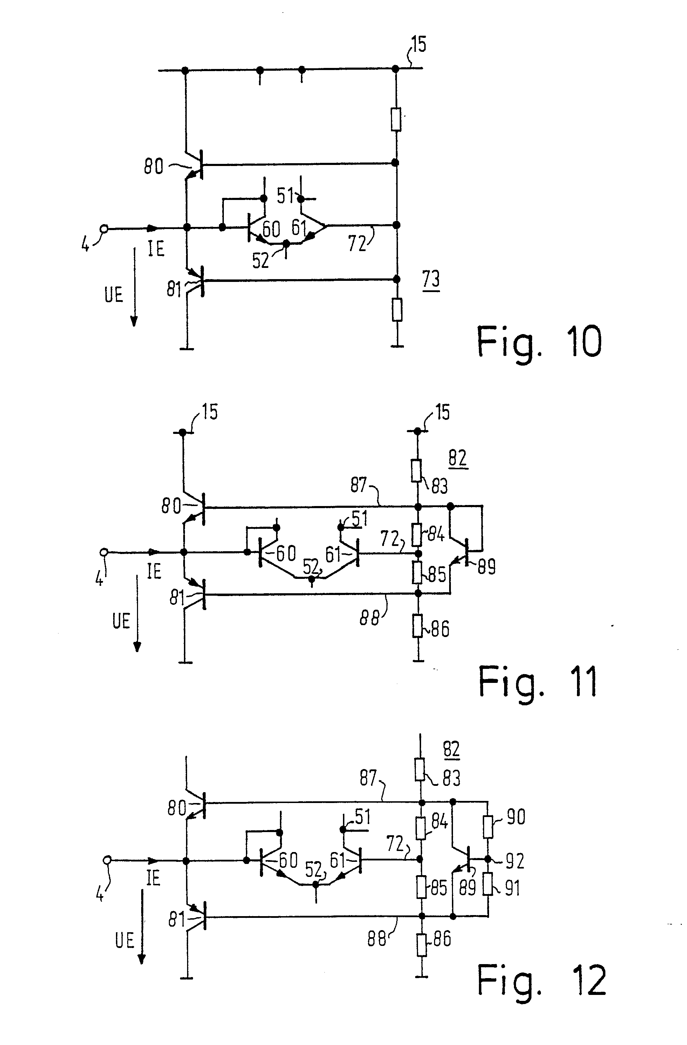

Ein solcher Spannungsverlauf wird auch im vorliegenden Ausführungsbeispiel durch die Anordnung von einen Überschußstrom führenden Zweigen erzielt. Ein Beispiel dafür ist in der Fig. 10 dargestellt, die eine Weiterbildung der Schaltungsanordnung nach Fig. 8 ist, wobei von den Elementen der Schaltungsanordnung nach Fig. 8 der Übersichtlichkeit halber nur diejenigen gezeichnet sind, an die sich die einen Überschußstrom führenden Zweige anschließen.

Die einen Überschußstrom führenden Zweige werden wieder durch Überschußstromtransistoren gebildet, und zwar ist die Kollektor-Emitter-Strecke eines ersten Überschußstromtransistors 80 zwischen dem positiven Anschluß der Stromversorgung 15 und dem Eingangsanschluß 4 und ein zweiter Überschußstromtransistor 81 mit seiner Emitter-Kollektor-Strecke zwischen dem Eingangsanschluß 4 und Masse angeordnet. Im vorliegenden Beispiel ist der erste Überschußstromtransistor 80 vom NPN-Typ und der zweite Überschußstromtransistor 81 vom PNP-Typ. Die Basisanschlüsse der Überschußstromtransistoren 80, 81 sind mit dem Abgriff 72 des Widerstandsspannungsteilers 73 verbunden.

Wenn kein Eingangsstrom IE fließt, stimmen die Spannungen am Eingangsanschluß 4 und am Abgriff 72 überein, so daß an den Basis-Emitter-Strecken der Überschußstromtransistoren 80, 81 keine Spannung anliegt und somit auch kein Strom fließt. Auch durch die geringfügigen Änderungen der Eingangsspannung UE, die innerhalb des Aussteuerungsbereiches des Eingangsstromes IE bzw. des Ausgangsstromes IA auftreten, werden in den Überschußstromtransistoren 80, 81 noch keine Überschußströme hervorgerufen. Diese treten erst dann auf, wenn die Spannung über der Basis-Emitter-Strecke eines der Transistoren 80, 81 die Flußspannung der Basis-Emitter-Diode des betreffenden Transistors überschreitet, beispielsweise 0,7 V. Dann fließt im ersten Überschußstromtransistor 80 ein Überschußstrom, wenn die Eingangsspannung UE am Eingangsanschluß 4 um beispielsweise 0,7 V unter die Referenzspannung am Abgriff 72 sinkt, und umgekehrt fließt im zweiten Überschußstromtransistor 81 ein Strom, wenn die Spannung UE die Referenzspannung am Abgriff 72 um beispielsweise 0,7 V übersteigt. Wenn dann der Eingangsstrom IE den Aussteuerungsbereich überschreitet, in dem der Ausgangsstrom IA linear von ihm abhängt, erhält man am Eingangsanschluß 4 die in Fig. 9 mit UE' bezeichneten Spannungsverläufe.

Bei der Schaltungsanordnung nach Fig. 10 beträgt der Variationsbereich der Eingangsspannung UE das Doppelte der Flußspannung einer der Basis-Emitter-Dioden der Überschußstromtransistoren 80, 81. Aus den erwähnten Gründen kann es erwünscht sein, diesen Variationsbereich noch weiter zu verringern. Das erstrebte Ziel dieser Verringerung ist ein völliges Verschwinden des Spannungssprunges zwischen dem Verlauf der Eingangsspannung UE im Aussteuerungsbereich und den Kurvenästen UE'. Allerdings kann es aus Gründen eines Toleranzausgleiches bei der Fertigung der beschriebenen Schaltung auch vorteilhaft sein, einen - wenn auch nur geringfügigen - Spannungssprung beizubehalten, der dann Streuungen im Verlauf der Eingangsspannung UE im begrenzten Aussteuerungsbereich ausgleicht, wodurch gegebenenfalls ein zu frühes Einsetzen eines Überschußstromes vermieden werden kann.

Fig. 11 zeigt eine Möglichkeit zur Verringerung des Variationsbereiches der Eingangsspannung UE. Dazu wird anstelle des Widerstandsspannungsteilers 73 ein abgewandelter Spannungsteiler 82, bestehend aus vier Widerständen 83, 84, 85, 86, verwendet. Zwischen dem zweiten Widerstand 84 und dem dritten Widerstand 85 dieses Spannungsteilers 82 ist der Abgriff 72 an den Basisanschluß des zweiten Transistors 61 herangeführt. An zwei weiteren Abgriffen 87, 88 zwischen dem ersten Widerstand 83 und dem zweiten Widerstand 84 bzw. dem dritten Widerstand 85 und dem vierten Widerstand 86 des Spannungsteilers 82 sind die Basisanschlüsse der Überschußstromtransistoren 80 bzw. 81 angeschlossen. Parallel zum zweiten und dritten Widerstand 84, 85 des Spannungsteilers 82, also zwischen den Abgriffen 87, 88, ist die Kollektor-Emitter-Strecke eines im Beispiel von Fig. 11 als Diode geschalteten Transistors 89 angeordnet, d. h. daß in diesem Beispiel auch der Basisanschluß des Transistors 89 mit dem ersten Abgriff 87 verbunden ist. Damit wird die Spannung zwischen dem ersten Abgriff 87 und dem zweiten Abgriff 88 auf die Flußspannung der Basis-Emitter-Diode des Transistors 89 festgelegt. Der Spannungshub der Eingangsspannung UE am Eingangsanschluß 4 beträgt dann, ausgehend von dem Spannungswert ohne Eingangsstrom IE, nur noch die halbe Flußspannung einer Basis-Emitter-Diode der Transistoren 80, 81 bzw. 89. Die Schaltungsanordnung nach Fig. 11 hat darüberhinaus den Vorteil, daß bei Schwankungen der Betriebstemperatur der Schaltungsanordnung sich die Änderungen der Flußspannungen der Basis-Emitter-Dioden in den Transistoren 80, 81 einerseits und 89 andererseits teilweise kompensieren, so daß eine Verringerung der Temperaturabhängigkeit der Grenzen des Spannungshubes der Eingangsspannung UE erreicht wird. Während bei der Schaltungsanordnung nach Fig. 11 die Grenzen des Spannungshubes der Eingangsspannung UE durch den Transistor 89 festgelegt sind, bietet eine Weiterentwicklung dieser Anordnung nach Fig. 12 den Vorteil eines einstellbaren Spannungshubes für die Eingangsspannung UE. Dazu wird der Basisanschluß des Transistors 89 mit dem Verbindungspunkt 92 zweier in Reihe geschalteter Widerstände verbunden, nämlich eines fünften Widerstandes 90 und eines sechsten Widerstandes 91, die zusammen einen zweiten Widerstandsspannungteiler bilden, der die Abgriffe 87 und 88 des Spannungsteilers 82 überbrückt. Zur Einstellung der Spannung zwischen dem ersten Abgriff 87 und dem zweiten Abgriff 88 werden bevorzugt der zweite, dritte und sechste Widerstand 84, 85 bzw. 91 auf einen übereinstimmenden Wert R festgesetzt, während der fünfte Widerstand 90 einen Wert (N-1)R erhält. Dabei ist N eine Variable, durch deren Veränderung die Spannung zwischen dem ersten Abgriff 87 und dem zweiten Abgriff 88 eingestellt werden kann.

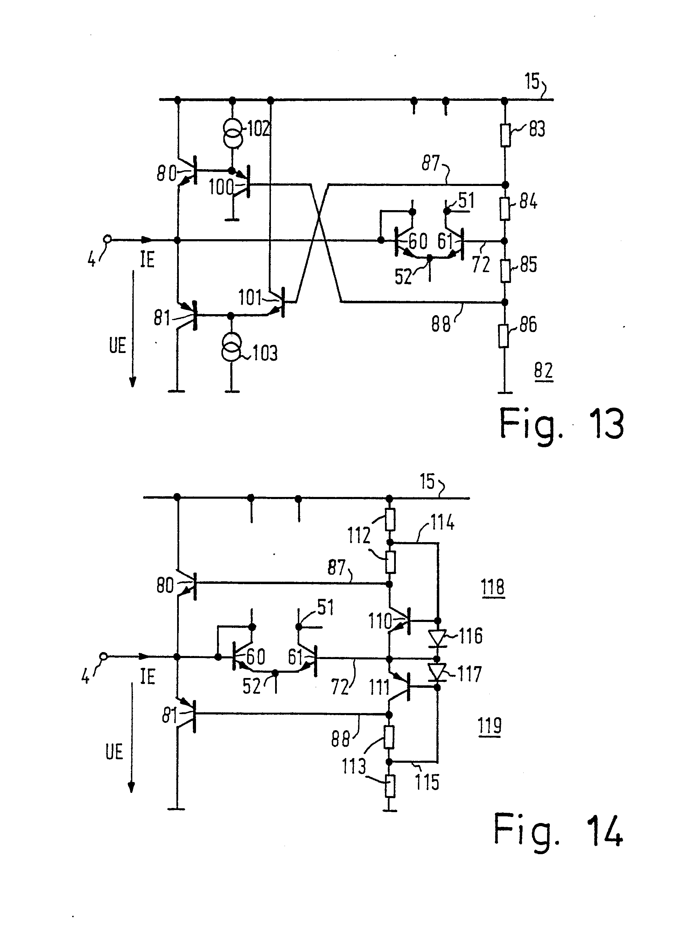

Eine noch bessere Kompensation der Temperaturabhängigkeit der Flußspannungen der Basis-Emitter-Dioden der Überschußstromtransistoren 80, 81, die die temperaturabhängige Veränderung des Spannungshubes der Eingangsspannung UE verursachen, wird beispielsweise mit einer Schaltungsanordnung gemäß Fig. 13 erreicht. Gegenüber den Figuren 11 und 12 wurden der Transistor 89 und der zweite Widerstandsspannungsteiler 90, 91 weggelassen und dafür die Abgriffe 87, 88 des Spannungsteilers 82 über die Basis-Emitter-Strecken je eines Kompensationstransistors 100, -101 mit den Basisanschlüssen des ersten bzw. des zweiten Überschußstromtransistors 80 bzw. 81 verbunden. Speziell ist dabei der zweite Abgriff 88 mit dem Basisanschluß des ersten Kompensationstransistors 100 und dessen Emitteranschluß mit dem Basisanschluß des ersten Überschußstrom transistors 80 sowie der erste Abgriff 87 mit dem Basisanschluß des zweiten Kompensationstransistors 101 und dessen Emitteranschluß mit dem Basisanschluß des zweiten Überschußstromtransistors 81 verknüpft. Die Kollektor-Emitter-Strecke des ersten Kompensationstransistors 100 ist mit einer mit dem zugehörigen Emitteranschluß verbundenen ersten Betriebsstromquelle 102 in Reihe zwischen dem positiven Anschluß der Stromversorgung 15 und Masse angeordnet, und die Kollektor-Emitter-Strecke des zweiten Kompensationstransistors 101 ist entsprechend mit einer mit dem Emitteranschluß dieses Kompensationstransistors 101 verbundenen zweiten Betriebsstromquelle 103 in Reihe zwischen dem positiven Anschluß der Stromversorgung 15 und Masse angeordnet. Die von den Betriebsstromquellen 102, 103 gelieferten Ströme sind so eingestellt, daß die Kollektor-Emitter-Strecken der Kompensationstransistoren 100, 101 einen Strom führen und über den Basis-Emitter-Dioden dieser Transistoren die Flußspannung abfällt, und zwar unabhängig vom Wert der Eingangsspannung UE. Diese Flußspannungen kompensieren dann genau die Flußspannungen über den Basis-Emitter-Dioden der zugehörigen Überschußstromtransistoren 80 bzw. 81, so daß der Spannungshub der Eingangsspannung UE temperaturunabhängig wird. Er wird durch Wahl der Werte des Spannungsteilers 82, insbesondere durch die Größe des zweiten und des dritten Widerstandes 84 bzw. 85, bestimmt.

Fig. 14 zeigt eine weitere Möglichkeit zur Gewährleistung eines temperaturunabhängigen Spannungshubes für die Eingangsspannung UE mit einem gegenüber der Fig. 13 verminderten Schaltungsaufwand. Dazu ist, ausgehend von einer Anordnung nach einer der Figuren 10 bis 12, der Widerstandsspannungsteiler 73 bzw. der Spannungsteiler 83 durch eine Reihenschaltung zweier Spannungsteiler 118 vom positiven Anschluß der Stromversorgung 15 zum Abgriff 72 und 119 vom Abgriff 72 nach Masse ersetzt. Jeder dieser Spannungsteiler 118, 119 entspricht der bereits zu Fig. 2 beschriebenen Referenzspannungsquelle 17, nur ist für das Ausführungsbeispiel der Fig. 14 die in Fig. 2 in der Referenzspannungsquelle 17 vorhandene zweite Diode 22 weggelassen und sind für den zweiten Spannungsteiler 119 die Polaritäten des zugehörigen Transistors 111 und der Diode 117 gegenüber der Ausführung der Referenzspannungsquelle 17 und des ersten Spannungsteilers 118 umgekehrt worden. Im übrigen entsprechen Widerstände 112, bzw. 113 dem Widerstand 19, Transistoren 110 bzw. 111 dem Transistor 18, Dioden 116 bzw. 117 der ersten Diode 21 sowie Abgriffe 114 bzw. 115 dem Abgriff 20. Durch Weglassen von der zweiten Diode 22 in der Referenzspannungsquelle 17 entsprechenden Dioden beträgt die Spannung zwischen dem Abgriff 72 und dem Abgriff 114 einerseits bzw. dem Abgriff 115 andererseits nur jeweils eine Diodenflußspannung. Diese kompensiert die Flußspannung der Basis-Emitter-Diode des ersten bzw. des zweiten Überschußstromtransistors 80 bzw. 81. Der erlaubte Spannungshub der Eingangsspannung UE wird wieder durch die Widerstände 112, 113, insbesondere durch Wahl der Werte der Widerstandteile zwischen den Abgriffen 114 und 87 bzw. zwischen 88 und 113, bestimmt.

## Ansprüche

1. Schaltungsanordnung zur Bildung eines in seiner Größe auf einen durch wenigstens einen Grenzwert berandeten Aussteuerungsbereich begrenzten Ausgangsstromes aus einem Eingangsstrom, gekennzeichnet durch ein Stromverknüpfungselement (1) zur Bildung einer wenigstens nahezu linearen Kombination des Eingangsstromes (IE), des Ausgangsstromes (IA) und eines festen Referenzstromes (IR) sowie wenigstens eine Gleichrichteranordnung (2) im Strompfad des Eingangs-(IE) und/oder des Ausgangsstromes (IA).

2. Schaltungsanordnung nach Anspruch 1, dadurch gekennzeichnet, daß Stromverknüpfungselement (1) und Gleichrichteranordnung (2) von einer Stromspiegelanordnung (10, 11, 12) umfaßt werden, in deren ersten Stromzweig (10, 12) ein Teil und in deren zweiten Stromzweig (11) die übrigen der eine wenigstens nahezu lineare Kombination bildenden Ströme (IE, IA, IR; IÜ) eingespeist werden.

3. Schaltungsanordnung nach Anspruch 1 oder 2, gekennzeichnet durch wenigstens ein weiteres Stromverknüpfungselement (30, 31), eine weitere Gleichrichteranordnung (32, 33, 34) und/oder einen weiteren Referenzstrom (IR1, IR2), wobei jedes Stromverknüpfungselement (30, 31) mit dem vorhergehenden über eine der Gleichrichteranordnungen (32, 33, 34) verbunden ist.

4. Schaltungsanordnung nach Anspruch 3, dadurch gekennzeichnet, daß wenigstens eines der Stromverknüpfungselemente (31) mit dem vorhergehenden (30) über eine wenigstens die Gleichrichteranordnung (32) umfassende Stromspiegelanordnung (41) verbunden ist.

5. Schaltungsanordnung nach Anspruch 1, 2, 3 oder 4, gekennzeichnet durch einen Transistor (60 bzw. 61), dessen Basis-Emitter-Strecke eine der Gleichrichteranordnungen (53 bzw. 54) und dessen Kollektoranschluß das mit letzterer verbundene Stromverknüpfungselement (50 bzw. 51) bilden.

6. Schaltungsanordnung nach Anspruch 5, dadurch gekennzeichnet, daß Kollektor-und Basisanschluß des Transistors (60) miteinander verbunden sind.

7. Schaltungsanordnung nach Anspruch 5, dadurch gekennzeichnet, daß dem Transistor (61) an seinem Basisanschluß eine Referenzspannung zugeführt wird.

8. Schaltungsanordnung nach Anspruch 3 in Verbindung mit Anspruch 1, gekennzeichnet durch einen ersten Transistor (60), dessen miteinander verbundener Basis-und Kollektoranschluß ein erstes (50) der Stromverknüpfungselemente und dessen Basis-Emitter-Strecke eine erste (53) der Gleichrichteranordnungen bilden, sowie einen zweiten Transistor (61), dessen Kollektoranschluß ein zweites (51) der Stromverknüpfungselemente und dessen Basis-Emitter-Strecke eine zweite (54) der Gleichrichteranordnungen bilden, wobei die miteinander verbundenen Emitteranschlüsse des ersten (60) und zweiten (61) Transistors ein drittes (52) der Stromverknüpfungselemente bilden, dem ersten Stromverknüpfungselement (50) der Eingangsstrom (IE) und ein erster Referenzstrom (IR1), dem dritten Stromverknüpfungselement außer den Emitterströmen des ersten (60) und zweiten (61) Transistors ein dritter Referenzstrom (IR3) und dem zweiten Stromverknüpfungselement (51) ein zweiter Referenzstrom (IR2) und der Ausgangsstrom (IA) zugeführt werden.

9. Schaltungsanordnung nach einem der vorhergehenden Ansprüche, dadurch gekennzeichnet, daß wenigstens ein Stromverknüpfungselement (1) mit wenigstens einem einen Überschußstrom (IÜ) führenden Zweig (6) verbunden ist.

10. Schaltungsanordnung nach Anspruch 9, dadurch gekennzeichnet, daß der Überschußstrom (IÜ) einen (weiteren) Ausgangsstrom darstellt.

11. Schaltungsanordnung nach Anspruch 9 oder 10, dadurch gekennzeichnet, daß jeder einen Überschußstrom führende Zweig (6) einen Überschußstromtransistor (16) umfaßt, dessen Emitter mit dem Stromverknüpfungselement (1), dessen Kollektor mit einem Anschluß einer Stromversorgung (15) und dessen Basis mit einer Referenzspannungsquelle (17) verbunden ist.

12. Schaltungsanordnung nach Anspruch 7 oder 11, dadurch gekennzeichnet, daß die Referenzspannung einer Anzapfung eines von der Referenzspannungsquelle (82, 89) umfaßten, zwischen dem Anschluß der Stromversorgung (15) und Masse angeordneten ersten Widerstandsspannungsteilers (84, 85) entnommen wird, dem die Kollektor-Emitter-Strecke eines Transistors (89) parallel geschaltet ist.

13. Schaltungsanordnung nach Anspruch 12, dadurch gekennzeichnet, daß der Basisanschluß des Transistors (89) mit dem Kollektoranschluß verbunden ist.

14. Schaltungsanordnung nach Anspruch 12, gekennzeichnet durch einen zweiten Widerstandsspannungsteiler (90, 91), der parallel zur Kollektor-Emitter-Strecke des Transistors (89) angeordnet und mit einem Abgriff (92) mit dem Basisanschluß des Transistors (89) verbunden ist.

15. Schaltungsanordnung nach Anspruch 14, dadurch gekennzeichnet, daß der Widerstandswert des ersten Widerstandsspannungsteilers (84, 85) zwischen dem Kollektor-und dem Emitteranschluß des Transistors (89) das Doppelte und der Widerstandswert des zwischen dem Kollektor-und dem Basisanschluß des Transistors (89) angeordneten Teils (90) des zweiten Widerstandsspannungsteilers (90, 91) das (N-1)-fache des Widerstandswertes des zwischen dem Basis-und dem Emitteranschluß des Transistors (89) angeordneten Teils (91) des zweiten Widerstandsspannungsteilers (90, 91) betragen, wobei N größer oder gleich 1 ist.

16. Schaltungsanordnung nach Anspruch 11, 12, 13, 14 oder 15, dadurch gekennzeichnet, daß die Referenzspannung der Referenzspannungsquelle (82) über die Basis-Emitter-Strecke eines Kompensationstransistors (100 bzw. 101) entnommen wird.

17. Schaltungsanordnung nach Anspruch 11, dadurch gekennzeichnet, daß die Referenzspannungsquelle (17; 118, 119) einen Transistor (18; 110, 111) umfaßt, dessen Basis-Emitter-Strecke eine in Flußrichtung gepolte erste Diode (21; 116, 117) parallel geschaltet und dessen Kollektor-Emitter-Strecke in Reihe mit einem mit dem Kollektoranschluß verbundenen Widerstand (19; 112, 113) angeordnet ist, wobei der Basisanschluß des Transi stors (18; 110, 111) mit einem Abgriff (20; 114, 115) des Widerstandes (19; 112, 113) verbunden ist und die Referenzspannung dem Kollektoranschluß entnommen wird.

18. Schaltungsanordnung nach Anspruch 17, dadurch gekennzeichnet, daß der Basisanschluß des Transistors (18) mit dem Abgriff (20) des Widerstandes (19) über eine in Flußrichtung gepolte zweite Diode (22) verbunden ist.

Fig. 1

Fig. 2

Fig. 4

Fig. 3

Fig. 5

Fig. 6

Fig. 7

Fig. 8

Fig. 9

Fig. 10

Fig. 11

Fig. 12

Fig. 13

Fig. 14

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | US-A-4 268 789 (NAGANO) <br> * Figur 5, Zusammenfassung * <br> --- | 1,2 | H 03 G 11/00 |
| Y | PATENT ABSTRACTS OF JAPAN, Band 8, Nr. 264 (E-282)[1701], 4. Dezember 1984; & JP - A - 59 134 914 (TOSHIBA) 02-08-1984 <br> --- | 1,2 | |
| P,A | WO-A-8 701 533 (BOSCH) <br> * figur 1; Zusammenfassung * <br> --- | | |
| D,A | WO-A-8 304 351 (MOTOROLA) <br> * Figur 2, Zusammenfassung * <br> ----- | | |

**RECHERCHIERTE SACHGEBIETE (Int. Cl.4)**

H 03 G 11/00
G 05 F 3/00

Der vorliegende Recherchenbericht wurde für alle Patentansprüche erstellt

| Recherchenort | Abschlußdatum der Recherche | Prüfer |
|---|---|---|
| BERLIN | 18-04-1988 | BREUSING J |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
.............................................................
& : Mitglied der gleichen Patentfamilie, übereinstimmendes Dokument

EPO FORM 1503 03.82 (P0403)